# EUROPEAN PATENT APPLICATION

(11) **EP 4 831 371 A1**
(43) Date of publication of application: **28.10.2026**
(21) Application number: 26174298.5
(22) Date of filing: 23.04.2026
(51) Int. Cl.: D03D 5/00, C08J 5/24, D03D 1/00, D03D 15/267, D06M 13/203, D06M 13/513, H05K 1/02

(54) **GLASS CLOTH**

(30) Priority: 24.04.2025 JP 2025072330
(71) Applicant: SHIN-ETSU CHEMICAL CO., LTD., Chiyoda-ku, Tokyo 1000005 (JP)
(72) Inventor: URANAKA, Kazuaki, Annaka-shi, Gunma 379-0192 (JP); TAGUCHI, Yusuke, Annaka-shi, Gunma 379-0192 (JP)
(74) Representative: Vossius & Partner Patentanwälte Rechtsanwälte mbB

(57) **Abstract**

[Problem]

The present invention has an object to provide a glass cloth that has superior dielectric characteristics and that is less liable to rupture, thus being superior in mass production capability.

[Means for Resolution]

A glass cloth comprising glass yarns as warp and weft: the warp comprising a warp (1) and a warp (2) which are two kinds of glass yarns having different SiO₂ composition ratios from each other, the warp (2) constituting at least one of both edge parts in a width direction of the glass cloth, all the edge parts woven with the warp (2) having an organic resin deposited thereon, T1 indicating a width of an area woven with the warp (2) and R1 indicating a width of an area having the organic resin deposited satisfying T1/R1 ≤ 1, the warp (1) being a glass yarn having an SiO₂ composition ratio of 90% by mass or more, and the warp (2) being a glass yarn having an SiO₂ composition ratio of 50% by mass or more and less than 90% by mass; and the weft being a glass yarn having an SiO₂ composition ratio of 90% by mass or more.

## Description

### Technical Field

The present invention relates to a glass cloth.

### Background Art

With the increase in the performance and the transmission speed of smartphones and other information terminals, a printed circuit board to be used therein is currently required to be increased in the density, to be reduced in the thickness, and to have low dielectric characteristics. A glass cloth to be used as an insulating material for the printed circuit board is also required to have a lower dielectric loss tangent. For example, as described in PTL 1, a glass cloth having improved dielectric characteristics is proposed. In addition, PTL 2 proposes a quartz glass cloth having a very low dielectric loss tangent due to a high SiO₂ composition ratio.

A glass cloth constituted only of a glass yarn having a SiO₂ composition ratio of 90% by mass or more has a very low dielectric loss tangent, but is harder and brittler as compared with glass clothes constituted of a glass having other components, and thus, there has been a problem of rupture of the glass cloth in winding.

As a countermeasure thereto, there is a method in which an organic resin is applied on both the edges in the width direction of the glass cloth to form reinforced parts referred to as selvage. However, this method has still not resolved the problem of rupture, fray, and the like of the glass cloth.

Since the rupture of the glass cloth affects the yield and the like in production of a printed circuit board, there has been a need for a solution to the problem.

### Citation List

### Patent Literature

PTL 1: WO 2021/205698 A1
PTL 2: JP 2021-195689 A

### Summary of Invention

### Technical Problem

Against the background as described above, the present invention has an object to provide a glass cloth that has superior dielectric characteristics and that is less liable to rupture, thus being superior in mass production capability.

### Solution to Problem

As a result of intensive and extensive studies for achieving the above object, the present inventors have found that rupture starts from both edge parts in the width direction of a glass cloth, in particular, starting from the portions of both edge parts on which an organic resin is deposited.

Specifically, the present inventors have found that a glass cloth includes glass yarns as the warp and the weft thereof, the glass warp yarn includes two kinds of glass yarns which is a warp (1) and a warp (2), the warp (1) is a glass yarn having an SiO₂ composition ratio of 90% by mass or more and a warp (2) is a glass yarn having an SiO₂ composition ratio of 50% by mass or more and less than 90% by mass, the glass weft yarn includes a glass yarn having an SiO₂ composition ratio of 90% by mass or more, the warp (2) constitutes at least one of both edge parts in the width direction of the glass cloth, all the edge parts woven with the warp (2) have an organic resin deposited thereon, the ratio of a width T1 of an area woven with the warp (2) and a width R1 of an area having the organic resin deposited falls within a predetermined range, and this can provide the glass cloth which can reduce ruptures from edge parts thereof to be superior in mass production capability, thus completing the present invention.

Thus, the present invention provides the following glass cloth.
[1] A glass cloth comprising glass yarns as warp and weft:
   the warp comprising a warp (1) and a warp (2) which are two kinds of glass yarns having different SiO₂ composition ratios from each other, the warp (2) constituting at least one of both edge parts in a width direction of the glass cloth, all the edge parts woven with the warp (2) having an organic resin deposited thereon, T1 indicating a width of an area woven with the warp (2) and R1 indicating a width of an area having the organic resin deposited satisfying T1/R1 ≤ 1, the warp (1) being a glass yarn having an SiO₂ composition ratio of 90% by mass or more, and the warp (2) being a glass yarn having an SiO₂ composition ratio of 50% by mass or more and less than 90% by mass; and
   the weft being a glass yarn having an SiO₂ composition ratio of 90% by mass or more.
[2] The glass cloth according to [1], wherein the glass cloth is surface-treated with a silane coupling agent and a part without the organic resin deposited has a dielectric loss tangent of 0.0008 or less at 10 GHz.

### Advantageous Effects of Invention

The present invention can provide a glass cloth that has superior dielectric characteristics and that is less liable to rupture, thus being superior in mass production capability.

### Brief Description of Drawings

Fig. 1 is a diagram schematically explaining the glass cloth of the present invention.
Fig. 2 is a diagram schematically explaining the glass cloth of the present invention.

### Description of Embodiments

The present invention will be described in detail below.

### [Glass Cloth]

The glass cloth of the present invention includes glass yarns as the warp and the weft. The glass cloth is characterized in that the warp of the glass cloth includes two kinds of glass yarns, a warp (1) and a warp (2) as described below, having different SiO₂ composition ratios from each other and that the warp (2) constitutes at least one of both edge parts in the width direction of the glass cloth.

The warp (1) is a glass yarn having an SiO₂ composition ratio of 90% by mass or more and the warp (2) is a glass yarn having an SiO₂ composition ratio of 50% by mass or more and less than 90% by mass.

The warp (2) constitutes at least one edge part of both edge parts in the width direction of the glass cloth. In particular, it is preferred that the warp (2) constitutes both the edge parts in the width direction of the glass cloth from the viewpoint of preventing rupture from both the edge parts. All the edge parts woven with the warp (2) have an organic resin deposited for preventing a fray. From the viewpoint of decreasing the dielectric loss tangent of the glass cloth, the width T1 of the edge part woven with the warp (2) and the width R1 of the area having the organic resin deposited satisfy T1/R1 ≤ 1, preferably 0.2 ≤ T1/R1 ≤ 1.

The width T1 is preferably 0.1 mm or more, and more preferably 0.5 to 10.0 mm.

The relation between the width T1 of the edge part woven with the warp (2) and the width R1 of the area having the organic resin deposited is explained below with reference to drawings. Note that the present invention is not to be limited to the drawings.

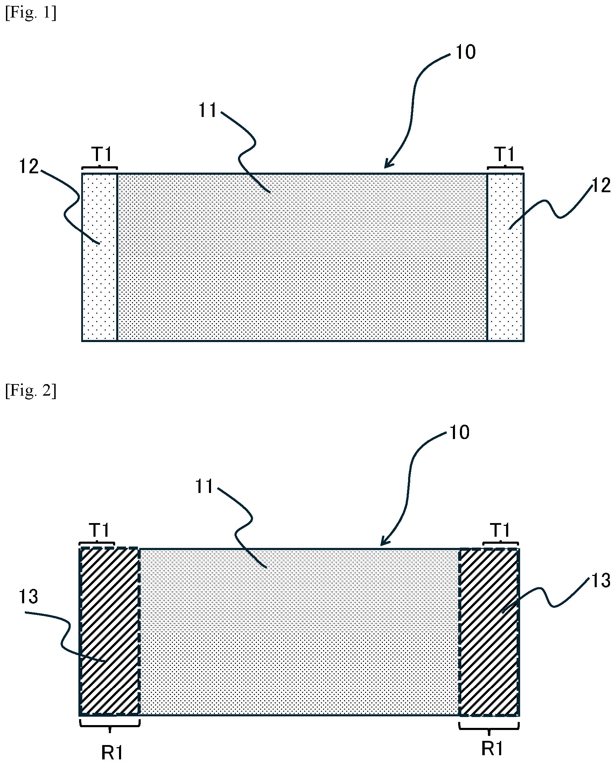

Fig. 1 shows a glass cloth 10 which schematically expresses one embodiment of the glass cloth of the present invention. Fig. 1 and Fig. 2 described later show diagrams of one surface of the glass cloth as viewed from above. The glass cloth 10 includes a region 11 woven with the warp (1) (a region including the center of the glass cloth 10) and a region 12 woven with the warp (2) on the outside (both the ends) in the width direction of the region 11 (both edge parts of the glass cloth 10). The region 12 woven with the warp (2) constitutes both edge parts of the glass cloth 10. The width of each of both the edge parts woven with the warp (2) is expressed by T1. Note that, although Fig. 1 shows an aspect in which both edge parts of the glass cloth are formed of the warp (2), a glass cloth in which only one edge part is formed of the warp (2) can also be adopted. In other words, the other edge part need not be formed of the warp (2), that is, the width T1 thereof may be 0, and in this case, T1/R1 in the other edge part is 0.

As shown in Fig. 2, in the glass cloth 10, an organic resin is preferably deposited on a region 13 including the whole of both the edge parts 12 woven with the warp (2). In Fig. 2, the organic resin is deposited on the region 12 (both the edge parts) and a part of the region 11 of the glass cloth 10, and the depositional width of the organic resin is expressed by R1.

As described above, the width T1 of the edge part and the depositional width R1 of the organic resin satisfy T1/R1 ≤ 1, and preferably 0.2 ≤ T1/R1 ≤ 1.

Note that, although the widths T1 of the opposite sides (the left end and right end in the drawings) of the glass cloth 10 are expressed as the same dimension in Figs. 1 and 2, the widths T1 may be different dimensions from each other. In addition, although the depositional widths R1 of the organic resin of the opposite sides (the left end and right end in the drawing) in the width direction of the glass cloth 10 are expressed as the same dimension in Fig. 2, the widths R1 may be different dimensions from each other.

When the widths T1 of the opposite sides in the width direction of the glass cloth 10 have different dimensions from each other or the widths R1 of the opposite sides have different dimensions from each other, the T1/R1 values of the opposite sides may be different. However, in this case, the T1/R1 values of the opposite sides both have to satisfy T1/R1 ≤ 1, and the T1/R1 values of the opposite sides both more preferably satisfy 0.2 ≤ T1/R1 ≤ 1.

The organic resin is not particularly limited, and examples thereof include a thermosetting resin and a UV-curable resin. Specific examples thereof include an epoxy resin, an ester resin, a polyether polymer, an amide resin, a urethane resin, and an acrylic resin. Among them, an epoxy resin and an ester resin are preferred.

Both the edge parts woven with the warp (2) and having an organic resin deposited are generally referred to as "selvage" in a glass cloth. The selvage may be partially or entirely cut off before use or may be left without cutting off, but is preferably partially cut off in terms of fray prevention.

In addition, the glass cloth of the present invention is characterized in that the whole weft is a glass yarn having an SiO₂ composition ratio of 90% by mass or more. This facilitates reduction of the dielectric loss tangent.

The weave of the glass cloth is not particularly limited, and examples thereof include plain weave, twill weave, sateen weave, and matt weave. Among them, plain weave is preferred.

The basis weight of the glass cloth is not particularly limited, and a glass cloth having a basis weight of 10 to 100 g/m² is suitably used.

The dielectric loss tangent at 10 GHz of the glass cloth in a part with no organic resin deposited after surface-treated with a silane coupling agent is preferably 0.0008 or less, and more preferably 0.0001 to 0.0005. Within the range, a glass cloth having superior dielectric characteristics is easily obtained. The part of the glass cloth without the organic resin deposited is preferably a part with a warp and a weft both having an SiO₂ composition ratio of 90% by mass or more, more preferably a part with a warp and a weft both having an SiO₂ composition ratio of 95% by mass or more, and further preferably a part with a warp and a weft both having an SiO₂ composition ratio of 99% by mass or more.

In the present invention, the dielectric loss tangent is measured with a cavity resonator.

### [Glass Yarn]

Examples of raw material glasses of the glass yarns for the warp (1) and the whole weft used in production of the glass cloth of the present invention include quartz glasses having an SiO₂ composition ratio of 90% by mass or more.

From the viewpoint of the dielectric characteristics, the warp (1) and the weft are each preferably a glass yarn having an SiO₂ composition ratio of 95% by mass or more, and more preferably a glass yarn having an SiO₂ composition ratio of 99% by mass or more. Note that the SiO₂ composition ratios of the warp (1) and the weft may be the same or different.

The warp (2) is not particularly limited as long as it is a glass yarn having an SiO₂ composition ratio of 50% by mass or more and less than 90% by mass, and examples thereof include an E glass having an SiO₂ composition ratio of 53% by mass, an S glass having an SiO₂ composition ratio of 64% by mass, a T glass having an SiO₂ composition ratio of 65% by mass, and a D glass having an SiO₂ composition ratio of 72% by mass.

The SiO₂ composition ratio of the warp (2) is preferably 50% by mass or more and 85% by mass or less, and more preferably 50% by mass or more and 80% by mass or less.

The thickness of the glass yarn used in the present invention is preferably 0.5 g/km to 30 g/km and more preferably 0.8 g/km to 20 g/km as the yarn count. For stabilizing the winding state, the yarn count of the glass yarn as the warp (2) is preferably equal to or smaller than the yarn count of the glass yarn as the warp (1).

### [Method for Producing Glass Cloth]

The method for producing the glass cloth of the present invention is not particularly limited as long as the method includes a step of weaving a glass yarn, and an example thereof is a method including the following steps:
(1) a warping step of warping a glass yarn to obtain a beam
(2) a weaving step of weaving glass yarns to obtain a glass cloth
(3) a deoiling step of removing a sizing agent deposited on the glass yarns of the glass cloth
(4) a silane-treatment step of surface-treating the glass cloth after the deoiling with a silane coupling agent
(5) a selvage-treatment step of depositing an organic resin on the glass cloth after the silane-treatment and curing the organic resin
(6) a slitting step of cutting a selvage-treated part in a winding direction.

### (1) Warping step

The warping step is a step of winding a predetermined number of a glass yarn on a beam according to the fabric density and the like. In warping, the glass yarn may be surface-protected with a secondary sizing agent mainly constituted of starch, PVA, or the like for preventing fluff and yarn breakage.

### (2) Weaving step

The weaving step is a step of weaving a weft into the beam obtained in the warping step to produce a glass cloth (raw glass cloth). The method for weaving is not particularly limited, and examples thereof include weaving methods by using an air jet loom, a water jet loom, a rapier loom, and a shuttle loom.

### (3) Deoiling step

In the deoiling step, the raw glass cloth is heated at 100°C to 1,500°C, whereby the secondary sizing agent, modified products thereof, and the like can be thermally removed. The heating amount, which is expressed by the product of the heating temperature (°C) of 100°C or higher and the heating time (h), is preferably 450 (°C·h) or more.

In the furnace used for heating, the heating atmosphere is preferably vacuum or a dry atmosphere having a dew point of 15°C or lower. The heating mechanism is not limited as long as such a furnace is used, and examples thereof include gas furnace, electric furnace, muffle furnace, and laser heating. Among them, electric furnace, muffle furnace, and laser heating are preferred.

The heating method is not particularly limited, and examples thereof include a batch system in which deoiling is performed in the winding state in a furnace and a roll-to-roll system having an unwinding mechanism and a winding mechanism in which deoiling is performed while conveying the glass cloth.

### (4) Silane-treatment step

The silane-treatment step provides a glass cloth surface-treated with a silane coupling agent. Specifically, as described below, the glass cloth is treated with a silane-treatment liquid containing a silane coupling agent.

The silane-treatment liquid for treating the glass cloth is not particularly limited, but, from the viewpoint of productivity and environmental load, an aqueous dispersion containing 0.05 to 1% by mass of a silane coupling agent is suitable. The aqueous dispersion can be prepared by adding a pH adjusting agent to the silane coupling agent. The pH adjusting agent is not particularly limited, but acetic acid or ammonia is preferably used according to the silane coupling agent used. The silane treatment is not particularly limited, and the glass cloth to be subjected to the silane treatment may be immersed in the aqueous dispersion. The temperature and the time are appropriately selected, for example, within the range of 50 to 200°C and the range of 30 seconds to 1 hour.

Examples of the silane coupling agent include alkoxysilane compounds, such as trimethylmethoxysilane, trimethylethoxysilane, dimethyldimethoxysilane, dimethyldiethoxysilane, methylphenyldimethoxysilane, methylphenyldiethoxysilane, diphenyldimethoxysilane, diphenyldiethoxysilane, trimethoxysilane, triethoxysilane, methyltrimethoxysilane, methyltriethoxysilane, phenyltrimethoxysilane, phenyltriethoxysilane, phenylmethylvinylethoxysilane, naphthyltrimethoxysilane, naphthyltriethoxysilane, 1,4-bis(methoxydimethylsilyl)benzene, tetramethoxysilane, tetraethoxysilane, n-propyltriethoxysilane, hexyltrimethoxysilane, octyltriethoxysilane, decyltrimethoxysilane, 1,6-bis(trimethoxysilyl)hexane, vinyltrimethoxysilane, vinyltriethoxysilane, p-styryltrimethoxysilane, 3-aminopropyltrimethoxysilane, 3-glycidoxypropyltrimethoxysilane, 3-glycidoxypropylmethyldimethoxysilane, 3-glycidoxypropyltriethoxysilane, 3-glycidoxypropylmethyldiethoxysilane, 2-(3,4-epoxycyclohexyl)ethyltrimethoxysilane, 2-(3,4-epoxycyclohexyl)ethylmethyldimethoxysilane, 3-methacryloxypropyltrimethoxysilane, 3-methacryloxypropyldimethoxysilane, 3-methacryloxypropyltriethoxysilane, 3-methacryloxypropyldiethoxysilane, N-(2-aminoethyl)-3-aminopropyltrimethoxysilane, N-(2-aminoethyl)-3-aminopropylmethyldimethoxysilane, N-(2-aminoethyl)-3-aminopropyltriethoxysilane, N-(2-aminoethyl)-3-aminopropylmethyldiethoxysilane, N-phenyl-3-aminopropyltrimethoxysilane, N-(vinylbenzyl)-2-aminoethyl-3-aminopropyltrimethoxysilane and a hydrochloric acid salt thereof, N-(vinylbenzyl)-2-aminoethyl-3-aminopropylmethyldimethoxysilane and a hydrochloric acid salt thereof, 3-isocyanatepropyltriethoxysilane, tris-(trimethoxysilylpropyl) isocyanurate, 3-ureidopropyltriethoxysilane, 3-chloropropyltrimethoxysilane, 3-mercaptopropyltrimethoxysilane, 3-mercaptopropylmethyldimethoxysilane, and bis(trisethoxysilylpropyl)tetrasulfide, and one of the compounds may be used or two or more thereof may be used in mixture. Among them, 3-aminopropyltrimethoxysilane, N-(2-aminoethyl)-3-aminopropyltrimethoxysilane, N-phenyl-3-aminopropyltrimethoxysilane, and the like are preferred. The silane coupling agent is not particularly limited thereto, and one kind may be used alone, or two or more kinds may be used in combination.

### (5) Selvage-treatment step

The selvage-treatment step is a step of applying and curing an organic resin for preventing a fault in the weave or the like, such as a fray of the yarn in cutting the glass cloth. The organic resin is not particularly limited, and examples thereof include a thermosetting resin and a UV-curable resin. The organic resin may be diluted with a solvent for even and thin application.

The method for applying the organic resin is not particularly limited, and can be appropriately selected from heretofore known methods, and examples thereof include roller coating, die coating, spray coating, and curtain coating. From the viewpoint of reducing variation in the application width, roller coating and die coating are preferred.

### (6) Slitting step

The slitting step is a step of cutting the glass cloth in the winding direction along the warp at a prescribed position of each of the selvage-treated parts to remove a part ranging from the corresponding edge of the glass cloth to the prescribed position of the selvage-treated part.

In addition, the glass cloth is generally preferably subjected to an opening treatment, for example, before the deoiling step or in the silane-treatment step, for increasing the impregnation capability with the resin in the following step. The method for the opening treatment is not particularly limited, and examples thereof include an opening treatment method by using ultrasonic waves, a method by high pressure columnar water jet, and a method by using gas-liquid mixture mist with an adjusted gas-water volume ratio. The method is appropriately selected according to the type of the glass cloth. Regardless of whether the opening is applied, the advantageous effects of the present invention can be achieved.

Each step in the method for producing a glass cloth is not always performed as a single step, and two or more steps can be performed together as one step. The order of the steps can be appropriately changed, if possible.

### Examples

The present invention will be specifically described below with reference to Examples and Comparative Examples, but the present invention is not limited to the Examples.

### (Example 1)

Warping was performed using a quartz glass yarn having an SiO₂ composition ratio of 99.9% by mass or more and a yarn count of 4.8 g/km as the warp (1) and an E glass yarn having an SiO₂ composition ratio of 53% by mass and a yarn count of 4.8 g/km as the warp (2) so that the warp (1) ranged to 632.5 mm each from the center in the glass cloth width and the warp (2) was arranged outside of the warp (1) in the width direction, followed by weaving with a quartz glass yarn having an SiO₂ composition ratio of 99.9% by mass or more and a yarn count of 4.8 g/km as the weft, whereby a glass cloth conforming to the IPC standard 1035 was produced. Then, the glass cloth was treated in an electric furnace B80×85×200-3Z12-10 manufactured by NEMS CO.,LTD. under the temperature which was raised to 400°C at 100°C/h, kept for 24 hours at 400°C, and decreased at 30°C/h. From the temperature increase to the temperature decrease in this process, dry air having a dew point of -20°C produced by an inverter package oil-free bebicon POD-15VNP manufactured by HITACHI, Ltd. was fed in an amount of five times the volume of the electric furnace per hour to perform a deoiling treatment.

Subsequently, a silane-coupling-treatment liquid was prepared. In purified water having an electric conductivity of 15 MΩ·cm produced by a pure water production system Milli-Q IX7010 manufactured by Merck KGaA, acetone manufactured by Tokyo Chemical Industry Co., Ltd. (boiling point 56°C) was mixed in such an amount that gave 20% by mass of acetone. Then, 0.1% by mass of acetic acid manufactured by Tokyo Chemical Industry Co., Ltd. was added as a hydrolysis condensation catalyst, and the mixture was stirred at 300 rpm at 25°C for 1 minute, thereby preparing a mixture liquid. With stirring continued, 3-methacryloxypropyltrimethoxysilane (product name KBM-503, manufactured by Shin-Etsu Chemical Co., Ltd.) which was filtered with a membrane filter DISMIC 13H manufactured by ADVANTEC TOYO KAISHA, Ltd. in advance was added in an amount corresponding to 0.2% by mass of the mixture liquid over 1 minute. The final composition was 20% by mass of acetone, 0.1% by mass of acetic acid, 0.20% by mass of KBM-503, and the balance of purified water. Then, the mixture was stirred at 25°C for 1 hour.

The glass cloth was impregnated with the silane-coupling-treatment liquid, which was put in advance in a silane treatment machine manufactured by HIRANO TECSEED Co., Ltd., and the extra treatment liquid was removed with a 150 µm gap, followed by drying at 110°C for 3 minutes to perform a silane treatment, thereby producing a silane-treated glass cloth. Subsequently, a selvage treatment agent containing 100 parts by mass of tricyclodecanedimethanol diacrylate which is a bifunctional acrylate and 0.5 parts by mass of Omnirad 819 (an α-hydroxyacetophenone compound manufactured by IGM Resins B.V) as a photopolymerization initiator was applied in an application width of 10 mm each from both the edges in the width direction of the glass cloth having a width of 1280 mm using a slitter (LP11A-00K-001) manufactured by Shin-Etsu Engineering Co., Ltd., and was irradiated with a 365-nm ultraviolet LED at an accumulated light amount of 500 mJ/cm² to cure the selvage treatment agent. Then, the glass cloth was slit at 5 mm from both the ends, thereby producing a glass cloth. In the glass cloth after slitting, the width T1 of the warp (2) and the width R1 of the organic resin deposited satisfied T1/R1 = 0.5.

### (Example 2)

A glass cloth was produced in the same manner as in Example 1 except for changing the warp (2) to a D glass yarn having an SiO₂ composition ratio of 72% by mass and a yarn count of 4.8 g/km. In the glass cloth after slitting, the width T1 of the warp (2) and the width R1 of the organic resin deposited satisfied T1/R1 = 0.5.

### (Example 3)

A glass cloth was produced in the same manner as in Example 1 except for changing the warp (2) to a glass yarn having a yarn count of 2.8 g/km. In the glass cloth after slitting, the width T1 of the warp (2) and the width R1 of the organic resin deposited satisfied T1/R1 = 0.5.

### (Comparative Example 1)

A glass cloth was produced in the same manner as in Example 1 except that warping was performed so that the warp (1) ranged to 627.5 mm each from the center in the glass cloth width and the warp (2) was arranged outside of the warp (1) in the width direction. In the glass cloth after slitting, the width T1 of the warp (2) and the width R1 of the organic resin deposited satisfied T1/R1 = 1.5.

### (Comparative Example 2)

A glass cloth was produced in the same manner as in Example 1 except for changing the warp (1) and the warp (2) to a quartz glass yarn having an SiO₂ composition ratio of 99.9% by mass or more and a yarn count of 4.8 g/km.

The glass cloths obtained were subjected to the following evaluations. The results are shown in Table 1.

### [1] Dielectric loss tangent of glass cloth

The dielectric loss tangent at 10 GHz of each glass cloth was measured with a cavity resonator (TE011 mode) manufactured by AET, Inc. Note that the theoretical thickness was used as the thickness of each glass cloth in the measurement and the theoretical thickness of each glass cloth was calculated according to the following equation. The dielectric loss tangent was measured on a part without the organic resin deposited.$Theoretical tichness t \left(μm\right) = basis weight \left({g / m}^{2}\right) / specific gravity \left({g / cm}^{3}\right)$

### [2] Check of crack generation in selvage parts in winding

Crack generation in the selvage parts when 2,000 m of the glass cloth was wound around an 18-cm diameter paper tube was checked.
A: The number of cracks in selvage parts was less than 5
B: The number of cracks in selvage parts was 5 or more

**[Table 1]**

| | | Example 1 | Example 2 | Example 3 | Comparative Example 1 | Comparative Example 2 |
|---|---|---|---|---|---|---|
| SiO₂ composition ratio of weft | % by mass | 99.9≤ | 99.9≤ | 99.9≤ | 99.9≤ | 99.9≤ |
| SiO₂ composition ratio of warp (1) | % by mass | 99.9≤ | 99.9≤ | 99.9≤ | 99.9≤ | 99.9≤ |
| SiO₂ composition ratio of warp (2) | % by mass | 53 | 72 | 53 | 53 | 99.9≤ |
| Yarn count of warp (1) | g/km | 4.8 | 4.8 | 4.8 | 4.8 | 4.8 |
| Yarn count of warp (2) | g/km | 4.8 | 4.8 | 2.8 | 4.8 | 4.8 |
| Width of warp (2) (T1) | mm | 2.5 | 2.5 | 2.5 | 7.5 | - |
| Width of organic resin deposited (R1) | mm | 5 | 5 | 5 | 5 | 5 |
| T1/R1 | - | 0.5 | 0.5 | 0.5 | 1.5 | - |
| Dielectric loss tangent @ 10GHz | - | 0.0004 | 0.0004 | 0.0004 | 0.0015 | 0.0004 |
| Crack generation in selvage parts | - | A | A | A | A | B |

As is evident from the results in Table 1, the glass cloth of the present invention has a low dielectric loss tangent, and is also less liable to generate cracks in the selvage parts which may cause rupture of the glass cloth, thus being superior in mass production capability.

On the other hand, when the width of the warp having an SiO₂ composition ratio of less than 90% is larger than the width of the organic resin deposited as in Comparative Example 1, the dielectric loss tangent deteriorates. In a glass cloth composed only of a quartz glass yarn having an SiO₂ composition ratio of 90% or more as in Comparative Example 2, many cracks are generated in the selvage parts and thus, the glass cloth ruptures in producing a prepreg and the like, leading to inferior productivity.

As described above, the glass cloth of the present invention satisfies both the dielectric characteristics required with the increased transmission speed, such as 5G, and the mass production capability, and is highly usable in the field of high speed communication and the like which has the above requirement.

Note that the present invention is not limited to the embodiment. The embodiment is merely an example, and any embodiments that have substantially the same configuration and the same effects as those of the technical idea described in the claims of the present invention are within the technical scope of the present invention.

### Reference Signs List

10: Glass cloth
11: Region woven with warp (1)
12: Region woven with warp (2)
13: Region having organic resin deposited

## Claims

1. A glass cloth comprising glass yarns as warp and weft:
the warp comprising a warp (1) and a warp (2) which are two kinds of glass yarns having different SiO₂ composition ratios from each other, the warp (2) constituting at least one of both edge parts in a width direction of the glass cloth, all the edge parts woven with the warp (2) having an organic resin deposited thereon, T1 indicating a width of an area woven with the warp (2) and R1 indicating a width of an area having the organic resin deposited satisfying T1/R1 ≤ 1, the warp (1) being a glass yarn having an SiO₂ composition ratio of 90% by mass or more, and the warp (2) being a glass yarn having an SiO₂ composition ratio of 50% by mass or more and less than 90% by mass; and
the weft being a glass yarn having an SiO₂ composition ratio of 90% by mass or more.

2. The glass cloth according to claim 1, wherein the glass cloth is surface-treated with a silane coupling agent and a part without the organic resin deposited has a dielectric loss tangent of 0.0008 or less at 10 GHz.
